# EUROPÄISCHE PATENTSCHRIFT

(11) **EP 4 122 002 B1**
(45) Veröffentlichungstag und Bekanntmachung des Hinweises auf die Patenterteilung: **26.06.2024**
(21) Anmeldenummer: 21715158.8
(22) Anmeldetag: 19.03.2021
(51) Int. Cl.: H01L 21/28, H01L 29/45, H01L 21/268

(54) **VERFAHREN ZUR ERZEUGUNG EINES OHMSCHEN KONTAKTS AUF EINER KRISTALLOGRAPHISCHEN C-SEITE EINES SILIZIUMKARBIDSUBSTRATS UND OHMSCHER KONTAKT**
METHOD FOR PRODUCING AN OHMIC CONTACT ON A CYRSTALLOGRAPHIC C-SIDE OF A SILICON CARBIDE SUBSTRATE, AND OHMIC CONTACT
PROCÉDÉ DE CRÉATION D'UN CONTACT OHMIQUE SUR UNE FACE C CRISTALLOGRAPHIQUE D'UN SUBSTRAT DE CARBURE DE SILICIUM ET CONTACT OHMIQUE

(30) Priorität: 20.03.2020 DE 102020203618
(43) Veröffentlichungstag der Anmeldung: 25.01.2023
(73) Patentinhaber: Robert Bosch GmbH, 70442 Stuttgart (DE)
(72) Erfinder: RODRIGUEZ ALVAREZ, Humberto, 70806 Kornwestheim (DE); ALSMEIER, Jan-Hendrik, 72793 Pfullingen (DE)
(86) Internationale Anmeldenummer: PCT/EP2021/057089
(87) Internationale Veröffentlichungsnummer: WO 2021/186031

(56) Entgegenhaltungen:
- JP-A- 2007 149 983
- US-A1- 2018 323 261

## Beschreibung

Die Erfindung betrifft ein Verfahren zur Erzeugung eines ohmschen Kontakts auf einer kristallographischen C-Seite eines Siliziumkarbidsubstrats und einen ohmschen Kontakt auf der kristallographischen C-Seite des Siliziumkarbidsubstrats.

### Stand der Technik

Das Dokument US 2018/323261 A1 beschreibt Siliziumkarbidhalbleiterbauelement und ein Verfahren zum Herstellen desselben.

Das Dokument JP 2007 149983 A offenbart ein Verfahren zum Herstellen eines lichtemittierenden Halbleiter auf Nitridbasis.

Das Dokument US 8440524 B2 beschreibt ein Verfahren zur Herstellung von Halbleiterbauelementen, insbesondere Mosfets, bei denen auf einer Seite des Halbleitersubstrats ein ohmscher Kontakt durch Erhitzen einer Metallschicht, die auf der Seite des Halbleitersubstrats angeordnet ist, mit Hilfe eines Lasers erzeugt wird.

Bei der Erzeugung ohmscher Kontakte auf Siliziumkarbidsubstraten werden somit eine oder mehrere Metallschichten auf das Halbleitersubstrat aufgebracht. Anschließend werden die Metallschichten mit Hilfe eines Lasers erhitzt, wobei die ohmschen Kontakte entstehen.

Nachteilig ist hierbei, dass sich bei der Erzeugung der ohmschen Kontakte Kohlenstoffbereiche durch die Reaktion von Siliziumkarbid und Metall unter Wärmezufuhr bilden. Dadurch wird die Anhaftung und die Zuverlässigkeit der ohmschen Kontakte beeinträchtigt.

Die Aufgabe der Erfindung ist es, diese Nachteile zu überwinden.

### Offenbarung der Erfindung

Das erfindungsgemäße Verfahren zur Erzeugung eines ohmschen Kontakts auf einer kristallographischen C-Seite eines Siliziumkarbidsubstrats umfasst das Aufbringen eines Schichtenstapels auf die kristallographische C-Seite des Siliziumkarbidsubstrats, wobei der Schichtenstapel mindestens eine halbleitende Schicht mit Germanium und mindestens eine metallische Schicht umfasst, und das Erzeugen einer punktuell, flüssigen Phase des Schichtenstapels, wobei eine Oberfläche des Schichtenstapels mit Hilfe von Laserstrahlen abgetastet wird.

Der Vorteil ist hierbei, dass der ohmsche Kontakt eine gute Anhaftung auf dem Siliziumkarbidsubstrat aufweist.

In einer Weiterbildung werden halbleitende Schichten und metallische Schichten alternierend auf die kristallographische C-Seite des Siliziumkarbidsubstrats aufgebracht.

In einer Ausgestaltung werden als metallische Schichten Nickel oder Titan aufgebracht.

Der Vorteil ist hierbei, dass die Schmelztemperatur niedrig ist.

In einer Weiterbildung werden als metallische Schichten Vanadium, Tantal, Niob, Zirconium, Molybdän, Wolfram oder eine Legierung dieser Metalle mit Nickel oder Titan aufgebracht. Mit anderen Worten es gibt mindestens eine metallische Schicht, die Nickel oder Titan umfasst und zusätzlich metallische Schichten die Vanadium, Tantal, Niob, Zirconium, Molybdän, Wolfram oder eine Legierung dieser Metalle mit Nickel oder Titan aufweisen.

Vorteilhaft ist hierbei, dass diese metallischen Elemente den Kohlenstoff binden.

In einer Ausgestaltung werden Schichtdicken der halbleitenden Schichten und Schichtdicken der metallischen Schichten von 3 nm bis 100 nm aufgebracht.

Der Vorteil ist hierbei, dass ein zuverlässiger und langlebiger Kontakt zum SiC erzeugt wird. Des Weiteren ist die Einkopplung des Laserlichts optimal.

In einer Weiterbildung wird zuerst die mindestens eine halbleitende Schicht mit Germanium auf das Siliziumkarbidsubstrat aufgebracht.

Vorteilhaft ist hierbei, dass die Schmelztemperaturen und die Löttemperaturen einen Wert im Bereich zwischen 900°C und 1000°C aufweisen.

In einer Ausgestaltung weisen die Laserstrahlen zum Erzeugen der punktuell, flüssigen Phase des Schichtenstapels einen Durchmesser von 10 µm bis 100 µm auf.

Der Vorteil ist hierbei, dass der Durchsatz trotz moderater Laserleistungen hoch ist, da das Abstasten der Oberfläche mit grösseren Durchmessern schneller erfolgen kann.

In einer Weiterbildung übertragen die Laserstrahlen mindestens eine Energiedichte von 1 J/cm2 auf eine Oberfläche des Schichtenstapels.

In einer Ausgestaltung liegt die Pulswiederholungsfrequenz der Laserstrahlen zwischen 10 kHz und 50 kHz.

Der Vorteil ist hierbei, dass die Anlagenkosten gering sind.

Der ohmsche Kontakt ist auf einer kristallographischen C-Seite eines Siliziumkarbidsubstrats angeordnet. Erfindungsgemäß ist infolge einer Laserbehandlung eine Schicht auf der kristallographischen C-Seite des Siliziumkarbidsubstrats angeordnet, die halbleitende Elemente mit Germanium und metallische Elemente umfasst.

Der Vorteil ist hierbei, dass der enstehende Kontakt einen niedrigen ohmschen Widerstand und eine hohe Haftung aufweist. Dies eignet sich besonders zur Herstellung eines Drainkontakts des Leistungshalbleiterbauelements.

In einer Weiterbildung sind die metallischen Elemente Nickel oder Titan.

Vorteilhaft ist hierbei, dass die Schmelztemperatur des Gemischs niedrig ist.

In einer weiteren Ausgestaltung umfassen die metallischen Elemente Vanadium, Tantal, Niob, Zirconium, Molybdän oder Wolfram.

Vorteilhaft ist hierbei, dass diese metallischen Elemente den Kohlenstoff binden. Mit anderen Worten diese Metalle fungieren als Getterelemente für den Kohlenstoff.

In einer Weiterbildung weist ein Kontaktwiderstand zwischen dem Siliziumkarbidsubstrat und der Schicht einen Wert kleiner 100 µΩ/cm2 bei einer Stromdichte größer 3A/mm2 auf.

Der Vorteil ist hierbei, dass ein vertikales Bauelement, z.B. ein MOSFET, mit solch einem Kontakt auf der Rückseite einen kleinen Widerstand im Durchlassfall aufweist.

Weitere Vorteile ergeben sich aus der nachfolgenden Beschreibung von Ausführungsbeispielen bzw. den abhängigen Patentansprüchen.

### Kurze Beschreibung der Zeichnungen

Die vorliegende Erfindung wird nachfolgend anhand bevorzugter Ausführungsformen und beigefügter Zeichnungen erläutert. Es zeigen:
- Figur 1: ein Verfahren zur Erzeugung eines ohmschen Kontakts auf einer kristallographischen C-Seite eines Siliziumkarbidsubstrats, und
- Figur 2: einen ohmschen Kontakt auf der kristallographischen C-Seite des Siliziumkarbidsubstrats.

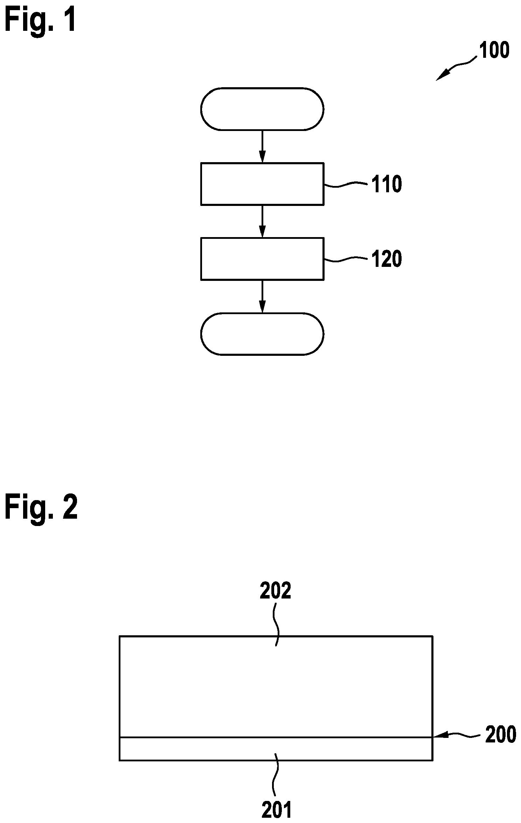

Figur 1 zeigt ein Verfahren 100 zur Erzeugung eines ohmschen Kontakts auf einer Rückseite, insbesondere einer kristallographischen C-Seite, eines Siliziumkarbidsubstrats. Das Verfahren startet mit einem Schritt 110, in dem ein Schichtenstapel auf die Rückseite des Siliziumkarbidsubstrats aufgebracht wird. Der Schichtenstapel umfasst mindestens eine halbleitende Schicht und mindestens eine metallische Schicht. Dabei werden die halbleitenden Schichten und die metallischen Schichten abwechselnd auf das Siliziumkarbidsubstrat aufgebracht. Mit anderen Worten der Schichtenstapel weist eine alternierende Folge von halbleitenden Schichten und metallischen Schichten auf. Dabei kann die Anzahl der halbleitenden Schichten und der metallischen Schichten verschieden sein. Mindestens eine der halbleitenden Schichten umfasst Germanium und die metallischen Schichten umfassen zumindest Nickel oder Titan. Zusätzlich können die metallischen Schichten Vanadium, Tantal, Niob, Zirconium, Molybdän, Wolfram oder eine Legierung dieser Metalle oder eine Legierung dieser Metalle mit Nickel oder Titan aufweisen. Die Schichtdicken der halbleitenden Schichten und die Schichtdicken der metallischen Schichten umfassen 3 nm bis 100 nm, insbesondere 5 nm - 20 nm. Die Dicke des Schichtenstapels beträgt zwischen 20 nm und 300 nm.

In einem ersten Ausführungsbeispiel ist eine halbleitende Schicht wie beispielsweise Germanium unmittelbar auf dem Siliziumkarbidsubstrat aufgebracht. Auf der halbleitenden Schicht ist eine metallische Schicht aufgebracht. Mit anderen Worten der Schichtenstapel weist eine halbleitende Schicht aus Germanium und eine metallische Schicht beispielsweise aus Nickel auf. Alternativ besteht die halbleitende Schicht aus mit Antimon oder Phosphor dotiertem Germanium. Der Vorteil ist hierbei dass diese Schicht mittels Kathodenzerstäubung aufgebracht werden kann.

In einem zweiten Ausführungsbeispiel ist eine halbleitende Schicht wie beispielsweise Germanium unmittelbar auf dem Siliziumkarbidsubstrat aufgebracht. Auf dieser halbleitenden Schicht werden abwechselnd metallische Schichten und halbleitende Schichten aufgebracht. Der Schichtenstapel weist beispielsweise eine erste halbleitende Schicht aus Germanium, eine erste metallische Schicht aus Nickel, eine zweite halbleitende Schicht aus Germanium und eine zweite metallische Schicht aus Vanadium auf. Dabei können die erste metallische Schicht und die zweite metallische Schicht vertauscht sein. Das bedeutet es ergibt sich eine Schichtenfolge aus Germanium, Vanadium, Germanium und Nickel. Alternativ kann die erste metallische Schicht eine Nickel-Vanadium-Legierung und die zweite metallische Schicht eine Vanadium-NickelLegierung aufweisen.

In einem dritten Ausführungsbeispiel umfasst der Schichtenstapel drei Schichten, zwei metallische Schichten und eine halbleitende Schicht. Eine metallische Schicht umfasst Nickel, die halbleitende Schicht Germanium und die andere metallische Schicht beispielsweise Vanadium. Dabei kann entweder die Nickelschicht oder die Vanadiumschicht unmittelbar auf dem Siliziumkarbidsubstrat angeordnet sein. Alternativ weist die andere metallische Schicht eine Nickel-Vanadium-Legierung auf.

In einem vierten Ausführungsbeispiel umfasst der Schichtenstapel drei Schichten, zwei metallische Schichten und eine halbleitende Schicht. Eine metallische Schicht umfasst Nickel, die halbleitende Schicht Germanium und die andere metallische Schicht beispielsweise Vanadium. Die einzelnen Schichten können dabei in beliebiger Reihenfolge aufeinander angeordnet sein. Mit anderen Worten die Schichtenreihenfolge des Schichtenstapels ergibt sich durch Permutation dieser drei Schichten. Das bedeutet, dass die beiden metallischen Schichten auch unmittelbar aufeinander folgen können. Somit weist der Schichtenstapel beispielsweise als Schichtenreihenfolge Nickel, Vanadium und Germanium oder Germanium, Nickel und Vanadium auf. Die Reihenfolge der Nickelschicht und der Vanadiumschicht kann ebenfalls vertauscht sein.

In einem fünften Ausführungsbeispiel umfasst der Schichtenstapel zwei Schichten. Die halbleitende Schicht aus Germanium ist unmittelbar auf dem Siliziumkarbidsubstrat aufgebracht, insbesondere auf der kristallographischen C-Seite. Die metallische Schicht umfasst Nickel und Vanadium, die von einem gemeinsamen Sputterobjekt mittels physikalischer Gasphasenabscheidung auf die halbleitende Schicht aufgebracht wird.

In einem folgenden Schritt 120 wird punktuell eine flüssige Phase des Schichtenstapels erzeugt, wobei eine Oberfläche des Schichtenstapels mit Hilfe von Laserstrahlen abgetastet wird. Dabei weisen die Laserstrahlen einen Durchmesser von 10 µm bis 100 µm auf. Die Pulswiederholungsfrequenz der Laserstrahlen liegt zwischen 10 kHz und 50 kHz. Die Pulsdauer des Laserstrahls liegt zwischen 10 und 100 ns. Die typische maximale Ausgangsleistung des dafür notwendigen Lasers liegt zwischen 1 und 100 W. Der Laser wird derart eingestellt, dass die Laserstrahlen mindestens eine Energiedichte von 1 J/cm2 pro Puls auf eine Oberfläche des Schichtenstapels übertragen, insbesondere 1,5 - 3 J/cm2. Dabei reagieren die metallischen Elemente Nickel oder Titan mit dem Silizium des Siliziumkarbidsubstrats. Die zusätzlichen metallischen Elemente wie Vanadium fungieren als Bindeelement für den Kohlenstoff, der sich durch die chemische Reaktion des Siliziumkarbids mit Nickel oder Titan unter Lasereinstrahlung bildet. Durch die Laserbehandlung vermischen sich die einzelnen Elemente aus dem Schichtenstapel, sodass eine gemischte Schicht auf der Rückseite des Siliziumkarbidsubstrats entsteht, an deren Übergang zum Siliziumkarbidsubstrat ein ohmscher Kontakt entsteht.

Figur 2 zeigt einen ohmschen Kontakt 200 auf einer Rückseite, insbesondere einer kristallographischen C-Seite eines Siliziumkarbidsubstrats 202. Auf einer Vorderseite des Siliziumkarbidsubstrats 202, die der Rückseite des Siliziumkarbidsubstrats 202 gegenüberliegt, sind beispielsweise die aktiven Bereiche eines Leistungstransistors angeordnet. Dies ist in Figur 2 nicht gezeigt. Auf der Rückseite des Siliziumkarbidsubstrats 202 ist infolge einer Laserbehandlung eine Schicht 201 angeordnet, die halbleitende Elemente und metallische Elemente umfasst. Das bedeutet der ohmsche Kontakt 200 befindet sich am Übergang zwischen dem Siliziumkarbidsubstrat 202 und der Schicht 201. Die halbleitenden Elemente in der Schicht 201 sind aus Germanium. Die Schicht 201 umfasst als metallische Elemente mindestens Nickel oder Titan. Zusätzlich kann die Schicht 201 metallische Elemente wie Vanadium, Tantal, Niob, Zirconium, Molybdän oder Wolfram umfassen. Diese zusätzlichen metallischen Elemente fungieren als Getterelement bzw. Bindeelement für den Kohlenstoff, der sich durch die chemische Reaktion des Siliziumkarbids mit Nickel oder Titan unter Lasereinstrahlung bildet. Der Kontaktwiderstand zwischen dem Siliziumkarbidsubstrat 202 und der Schicht 201 weist einen Wert kleiner 100 µΩ/cm2 bei einer Stromdichte größer 3A/mm2.

Leistungstransistoren wie Mosfets können die erfindungsgemäßen ohmschen Kontakte aufweisen. Diese Leistungstransistoren finden Anwendung in leistungselektronischen Bauelementen wie Invertern für Elektrofahrzeuge oder Hybridfahrzeuge, Invertern für Photovoltaikanlagen und Windkraftanlagen, sowie in Zugantrieben und Hochspannungsgleichrichtern.

## Patentansprüche

1. Verfahren (100) zur Erzeugung eines ohmschen Kontakts auf einer kristallographischen C-Seite eines Siliziumkarbidsubstrats mit den Schritten:
• Aufbringen (110) eines Schichtenstapels auf die kristallographische C-Seite des Siliziumkarbidsubstrats, wobei der Schichtenstapel mindestens eine halbleitende Schicht mit Germanium und mindestens eine metallische Schicht umfasst, und
• Erzeugen (120) einer punktuell, flüssigen Phase des Schichtenstapels, wobei eine Oberfläche des Schichtenstapels mit Hilfe von Laserstrahlen abgetastet wird, wobei die metallische Schicht mit dem Silizium des Siliziumkarbidsubstrats reagiert.

2. Verfahren (100) nach Anspruch 1, **dadurch gekennzeichnet, dass** halbleitende Schichten und metallische Schichten alternierend auf die kristallographische C-Seite des Siliziumkarbidsubstrats aufgebracht werden.

3. Verfahren (100) nach einem der Ansprüche 1 oder 2, **dadurch gekennzeichnet, dass** als metallische Schichten Nickel oder Titan aufgebracht werden.

4. Verfahren (100) nach Anspruch 3, **dadurch gekennzeichnet, dass** als metallische Schichten Vanadium, Tantal, Niob, Zirconium, Molybdän, Wolfram oder eine Legierung dieser Metalle mit Nickel oder Titan aufgebracht werden.

5. Verfahren (100) nach einem der vorhergehenden Ansprüche, **dadurch gekennzeichnet, dass** Schichtdicken der halbleitenden Schichten und Schichtdicken der metallischen Schichten von 3 nm bis 100 nm aufgebracht werden.

6. Verfahren (100) nach einem der vorhergehenden Ansprüche, **dadurch gekennzeichnet, dass** zuerst die mindestens eine halbleitende Schicht mit Germanium auf das Siliziumkarbidsubstrat aufgebracht wird.

7. Verfahren (100) nach einem der vorhergehenden Ansprüche, **dadurch gekennzeichnet, dass** die Laserstrahlen zum Erzeugen der punktuell, flüssigen Phase des Schichtenstapels einen Durchmesser von 10 µm bis 100 µm aufweisen.

8. Verfahren (100) nach einem der vorhergehenden Ansprüche, **dadurch gekennzeichnet, dass** die Laserstrahlen mindestens eine Energiedichte von 1 J/cm2 auf eine Oberfläche des Schichtenstapels übertragen.

9. Verfahren (100) nach einem der vorhergehenden Ansprüche, **dadurch gekennzeichnet, dass** die Pulswiederholungsfrequenz der Laserstrahlen zwischen 10 kHz und 50 kHz liegt.

10. Ohmscher Kontakt (200) auf einer kristallographischen C-Seite eines Siliziumkarbidsubstrats (202), wobei eine Schicht (201) auf der kristallographischen C-Seite des Siliziumkarbidsubstrats angeordnet ist, die halbleitende Elemente mit Germanium und metallische Elemente umfasst, wobei der ohmscher Kontakt mittels des Verfahrens nach Anspruch 1 erzeugt ist.

11. Ohmscher Kontakt (200) nach Anspruch 10, **dadurch gekennzeichnet, dass** dass die metallischen Elemente Nickel oder Titan umfassen.

12. Ohmscher Kontakt (200) nach Anspruch 11, **dadurch gekennzeichnet, dass** die metallischen Elemente Vanadium, Tantal, Niob, Zirconium, Molybdän oder Wolfram umfassen.

13. Ohmscher Kontakt (200) nach einem der Ansprüche 10 bis 12, **dadurch gekennzeichnet, dass** ein Kontaktwiderstand zwischen dem Siliziumkarbidsubstrat (202) und der Schicht (201) einen Wert kleiner 100 µΩ/cm2 aufweist bei einer Stromdichte größer 3A/mm2.

## Claims

1. Method (100) of creating an ohmic contact on a crystallographic C side of a silicon carbide substrate, comprising the following steps:
• applying (110) a layer stack to the crystallographic C side of the silicon carbide substrate, where the layer stack comprises at least one semiconductive layer comprising germanium and at least one metallic layer, and
• creating (120) a liquid phase, in the form of dots, of the layer stack, wherein a surface of the layer stack is scanned with the aid of laser beams, wherein the metallic layer reacts with the silicon in the silicon carbide substrate.

2. Method (100) according to Claim 1, **characterized in that** semiconductive layers and metallic layers are applied alternately to the crystallographic C side of the silicon carbide substrate.

3. Method (100) according to either of Claims 1 and 2, **characterized in that** the metallic layers applied are nickel or titanium.

4. Method (100) according to Claim 3, **characterized in that** the metallic layers applied are vanadium, tantalum, niobium, zirconium, molybdenum, tungsten or an alloy of these metals with nickel or titanium.

5. Method (100) according to any of the preceding claims, **characterized in that** layer thicknesses of the semiconductive layers and layer thicknesses of the metallic layers of 3 nm to 100 nm are applied.

6. Method (100) according to any of the preceding claims, **characterized in that** the at least one semiconductive layer comprising germanium is applied first to the silicon carbide substrate.

7. Method (100) according to any of the preceding claims, **characterized in that** the laser beams for creation of the liquid phase, in the form of dots, of the layer stack have a diameter of 10 um to 100 µm.

8. Method (100) according to any of the preceding claims, **characterized in that** the laser beams transmit at least an energy density of 1 J/cm² to a surface of the layer stack.

9. Method (100) according to any of the preceding claims, **characterized in that** the pulse repeat frequency of the laser beams is between 10 kHz and 50 kHz.

10. Ohmic contact (200) on a crystallographic C side of a silicon carbide substrate (202), wherein a layer (201) disposed on the crystallographic C side of the silicon carbide substrate comprises semiconductive elements comprising germanium and metallic elements, wherein the ohmic contact has been created by the method according to Claim 1.

11. Ohmic contact (200) according to Claim 10, **characterized in that** the metallic elements comprise nickel or titanium.

12. Ohmic contact (200) according to Claim 11, **characterized in that** the metallic elements comprise vanadium, tantalum, niobium, zirconium, molybdenum or tungsten.

13. Ohmic contact (200) according to any of Claims 10 to 12, **characterized in that** a contact resistance between the silicon carbide substrate (202) and the layer (201) has a value of less than 100 µΩ/cm² at a current density of greater than 3 A/mm².

## Revendications

1. Procédé (100) destiné à générer un contact ohmique sur une face cristallographique C d'un substrat en carbure de silicium, présentant les étapes de :
• application (110) d'une pile de couches sur la face cristallographique C du substrat en carbure de silicium, la pile de couches comprenant au moins une couche semi-conductrice comportant du germanium et au moins une couche métallique et
• génération (120) de façon ponctuelle d'une phase liquide de la pile de couches, une surface de la pile de couches étant balayée à l'aide de rayons laser, la couche métallique réagissant avec le silicium du substrat en carbure de silicium.

2. Procédé (100) selon la revendication 1, **caractérisé en ce que** des couches semi-conductrices et des couches métalliques sont appliquées en alternance sur la face cristallographique C du substrat en carbure de silicium.

3. Procédé (100) selon l'une des revendications 1 ou 2, caractérisé ce que du nickel ou du titane sont appliqués en tant que couches métalliques.

4. Procédé (100) selon la revendication 3, **caractérisé en ce que** du vanadium, du tantale, du niobium, du zirconium, du molybdène, du tungstène ou un alliage de ces métaux avec du nickel ou du titane sont appliqués en tant que couches métalliques.

5. Procédé (100) selon l'une des revendications précédentes, **caractérisé en ce que** des épaisseurs de couche des couches semi-conductrices et des épaisseurs de couche des couches métalliques de 3 nm à 100 nm sont appliquées.

6. Procédé (100) selon l'une des revendications précédentes, **caractérisé en ce que** ladite au moins une couche semi-conductrice comportant du germanium est appliquée en premier lieu sur le substrat en carbure de silicium.

7. Procédé (100) selon l'une des revendications précédentes, **caractérisé en ce que** les rayons laser destinés à générer ponctuellement la phase liquide de la pile de couches présentent un diamètre de 10 um à 100 um.

8. Procédé (100) selon l'une des revendications précédentes, **caractérisé en ce que** les rayons laser transfèrent au moins une densité énergétique de 1 J/cm² sur une surface de la pile de couches.

9. Procédé (100) selon l'une des revendications précédentes, **caractérisé en ce que** la fréquence de répétition d'impulsion des rayons laser est située entre 10 kHz et 50 kHz.

10. Contact ohmique (200) sur une face cristallographique C d'un substrat en carbure de silicium (202), une couche (201) étant agencée sur la face cristallographique C du substrat en carbure de silicium, qui comprend des éléments semi-conducteurs comportant du germanium et des éléments métalliques, le contact ohmique étant généré au moyen du procédé selon la revendication 1.

11. Contact ohmique (200) selon la revendication 10, **caractérisé en ce que** les éléments métalliques comprennent du nickel ou du titane.

12. Contact ohmique (200) selon la revendication 11, **caractérisé en ce que** les éléments métalliques comprennent du vanadium, du tantale, du niobium, du zirconium, du molybdène ou du tungstène.

13. Contact ohmique (200) selon l'une des revendications 10 à 12, **caractérisé en ce qu'**une résistance de contact entre le substrat en carbure de silicium (202) et la couche (201) présente une valeur inférieure à 100 µΩ/cm² à une densité de courant supérieure à 3 A/mm².
